# EUROPÄISCHE PATENTANMELDUNG

(11) **EP 0 664 350 A1**
(43) Veröffentlichungstag der Anmeldung: **26.07.1995**
(21) Anmeldenummer: 95100725.1
(22) Anmeldetag: 19.01.1995
(51) Int. Cl.: C30B 19/02

(54) **Verfahren und Vorrichtung zur Herstellung kristalliner Schichten**

(30) Priorität: 20.01.1994 DE 4401626
(71) Anmelder: Max-Planck-Gesellschaft zur Förderung der Wissenschaften e.V., D-80539 München (DE)
(72) Erfinder: Bauser, Elisabeth, Dr. Dipl.-Phys., D-70569 Stuttgart (DE); Konuma, Mitsuharu, Dr., D-70195 Stuttgart (DE)
(74) Vertreter: Schütz, Peter, Dipl.-Ing.

(57) **Zusammenfassung**

Verfahren zur Herstellung kristalliner Schichten, bei welchem die Resultante der auf eine über dem Substrat (2a) befindlichen flüssigen Lösung einwirkenden Kräfte, insbesondere der Zentrifugalkraft, auf der Substratoberfläche senkrecht steht, wodurch ein Konzentrationsmaximum des in der Flüssigkeit gelösten abzuscheidenden Materials in unmittelbarer Nähe der Substratoberfläche entsteht. Die Lösung kann "in situ" nachgesättigt werden durch aus einer Vorratsplatte (2b) gelöstes abzuscheidendes Material, das in Richtung auf das Substrat transportiert wird. Als Vorrichtung dient ein zylinder- oder kegelstumpfförmiger, doppelwandiger Tiegel (10).

## Beschreibung

Die Erfindung betrifft ein Verfahren zur Ausbildung einer Schicht nach dem Oberbegriff des Anspruchs 1 und eine Vorrichtung zu seiner Durchführung. Insbesondere betrifft die Erfindung ein Verfahren zur Herstellung von einkristallinen und polykristallinen dünnen Schichten auf einkristallinen, polykristallinen, amorphen oder sonstigen Unterlagen (Substraten), wobei das Substrat aus der gleichen Substanz wie die dünne Schicht besteht (Epitaxie), oder aus einer anderen Substanz besteht als die dünne Schicht.

Die Herstellung von dünnen, kristallinen Schichten aus verschiedenen Materialien ist für zahlreiche Anwendungen von großer Bedeutung. Aktuelle Anwendungsbeispiele aus dem Gebiet der Halbleitertechnik sind Dünnschichtsolarzellen. Bei dieser und zahlreichen Anwendungen sollen die Minoritätsladungsträger-Lebensdauern hoch sein, und zwar mindestens so hoch, daß die freie Weglänge der Minoritätsträger groß ist im Vergleich zur Dicke der kristallinen Schicht. Deshalb sind bei derartigen Anwendungen Schichten mit insgesamt niedriger Defektdichte bzw. niedriger Dichte an Ladungsträger-Rekombinationszentren stets anderen Schichten überlegen, die eine höhere Dichte an Rekombinationszentren aufweisen. Kristalline Halbleiterschichten, die durch Flüssigphasenepitaxie aus einer Lösung gezüchtet sind, weisen eine im Vergleich sehr niedrige Dichte an Defekten und insbesondere an Ladungsträger-Rekombinationszentren auf. Voraussetzung ist natürlich, daß die Herstellung unter geeigneten Bedingungen vorgenommen wird.

Für die Erzeugung einer Schicht von hoher Qualität und Defektfreiheit ist man zumeist noch auf die Verwendung hochwertiger und entsprechend teurer Substrate angewiesen. Andererseits ist man in zunehmendem Maße an der Verwendung von äußerst billigen Substraten als Trägermaterialien für die dünnen Schichten interessiert, deren Kristallinität, Volumeneigenschaften und Oberflächenmorphologie nicht perfekt sind. Bei der Herstellung hochwertiger kristalliner Schichten auf derartigen Trägermaterialien hat man das Bestreben, die Herstellungstemperatur für die kristallinen Schichten möglichst niedrig zu halten. Die Vorteile einer niedrigen Herstellungstemperatur sind: Die Vermeidung bzw. Reduzierung unerwünschter Wechselwirkung mit dem Trägermaterial, die resultierende hohe Qualität der kristallinen Schichten, die sich durch eine weitgehende Rekombinationszentrenfreiheit bei entsprechend niedrigen Defektdichten manifestiert, sowie Energieersparnis. Je höher die Wachstumstemperatur, desto höher ist aus thermodynamischen Gründen die Dichte atomarer Fehlstellen. Bei der Kristallzüchtung aus der Lösung arbeitet man meist weit unterhalb der Schmelztemperatur des kristallinen Materials. Man vermeidet also die hohen Temperaturen, die z.B. beim Aufschmelzen und anschließenden Rekristallisieren eines Materials erforderlich sind.

Allerdings ist bei Anwendungen des Kristallwachstums aus der Lösung mitunter eine starke Übersättigung der Lösung notwendig. Bei hoher Übersättigung der Lösung im gesamten Volumen kann unerwünschte homogene spontane Keimbildung auftreten mit anschließendem parasitärem Wachstum dieser Keime. Das Wachstum dieser unerwünschten Keime führt zur Entsättigung der Lösung zu Ungunsten des vorgesehenen Kristallisationsprozesses.

Ein weiterer Nachteil des Standes der Technik ist, daß zu einer ständigen Nachsättigung der Lösung die Aufrechterhaltung einer Temperaturdifferenz im Züchtungssystem erforderlich ist.

Es ist daher Aufgabe der vorliegenden Erfindung, ein Verfahren zur Ausbildung einer kristallinen Schicht auf einem Substrat anzugeben, das mit verbesserten Züchtungsbedingungen arbeiten kann.

Diese Aufgabe wird mit den kennzeichnenden Merkmalen des Anspruchs 1 gelöst. Vorteilhafte Ausgestaltungen sind in den Unteransprüchen angegeben.

Mit der Erfindung werden insbesondere folgende Vorteile erzielt.

Durch den erfindungsgemäßen Einsatz von Flieh- oder Zentrifugalkräften können die treibenden Kräfte für das Kristallwachstum bei der Abscheidung aus der flüssigen Phase erhöht werden. Fliehkräfte wurden bei der in der Deutschen Patentanmeldung 3 604 260 ("Flüssigkeitsepitaxieverfahren zum Herstellen dreidimensionaler Halbleiterstrukturen") beschriebenen Vorrichtung zur Flüssigphasenepitaxie eingesetzt, um das Lösungsmittel auf das Substrat zu leiten und nach Erreichen der beabsichtigten Schichtdicke wieder vom Substrat zu entfernen. Bei der vorliegenden Erfindung wird die Fliehkraft nicht nur zum Transport und zur Positionierung der flüssigen Lösung eingesetzt, sondern insbesondere zur Erhöhung der treibenden Kraft für das Kristallwachstum, d.h. zur Steuerung der lokalen Übersättigung der Lösung an der Wachstumsfläche. Damit verbessert sich die Kontrollierbarkeit des Kristallwachstums erheblich.

Bei kristallinen Substraten wirkt sich dies in der Weise positiv aus, daß die Wachstumsrate erhöht werden kann, so daß auch bei niedrigen Temperaturen große Schichtdicken erzielt werden können. Bei Fremd-Substraten und nichtkristallinen Substraten wird der Wachstumsprozeß erleichtert durch die hohe Übersättigung und die dadurch bedingte erhöhte Keimbildungswahrscheinlichkeit an der Substratoberfläche und die erniedrigte parasitäre Keimbildung im Lösungsvolumen.

Die Anwendung der Fliehkraft bei dem erfindungsgemäßen Verfahren erlaubt weiterhin, die Lösung ständig "in situ" nachzusättigen. Diese ständige "in situ" Nachsättigung kann zudem in einem isothermen Züchtungssystem durchgeführt werden.

Ein weiterer Vorteil liegt in dem verbesserten Wachstumsverhalten bei Substraten von minderer Qualität, z.B. solchen, deren Oberflächenmorphologie nicht perfekt ist. Hier bewirkt die über der Substratoberfläche erzeugte erhöhte Konzentration des der Schichtbildung dienenden, in der Lösung befindlichen Materials einen Druck, mit dem das Material auf das Substrat gepreßt wird.

Besondere Vorteile verspricht das erfindungsgemäße Verfahren für eher schwierige Wachstumsprozesse, wie z.B. das Aufwachsen hochwertiger, ein- oder polykristalliner Halbleiterschichten auf einem beliebigen Trägermaterial, wie z.B. Glas oder Dachziegeln, insbesondere zur Herstellung von Solarzellen. Auch für die Heteroepitaxie (z.B. Si auf Ge), bei der mit Gitterfehlanpassungen zu rechnen ist, verspricht die Anwendung des erfindungsgemäßen Verfahrens verbesserte Erfolgsaussichten.

Die Erfindung wird im folgenden anhand der Figuren näher erläutert.

Es zeigen:
- Fig. 1: eine schematische Querschnittsansicht einer möglichen Ausführungsform zur Durchführung des erfindungsgemäßen Verfahrens (nicht maßstabsgetreu);
- Fig. 2: ein Schaubild zur Erläuterung der Ausbildung eines Konzentrationsgefälles des der Schichtbildung dienenden, in der Lösung befindlichen Materials am Beispiel Si in Ga.

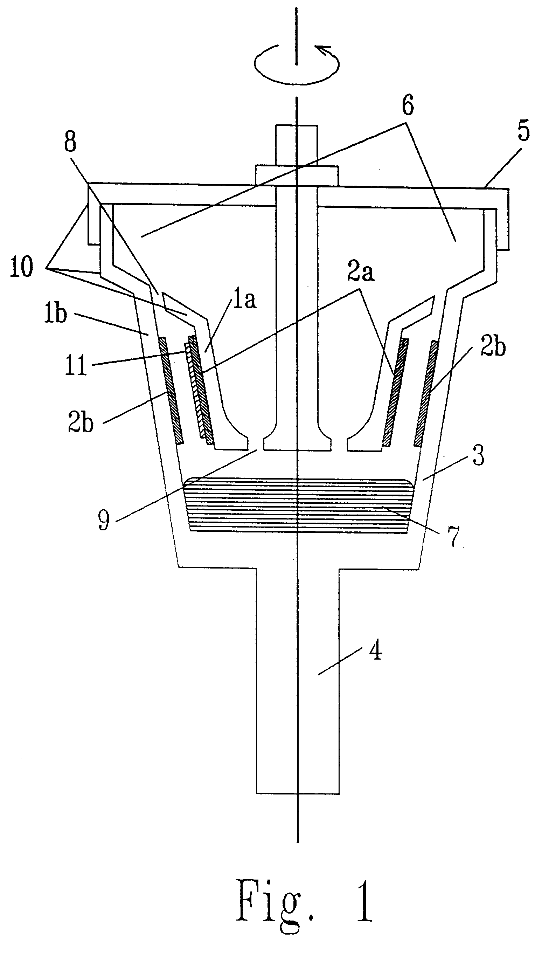

Das erfindungsgemäße Verfahren wird nun beispielhaft und ohne Einschränkung der Allgemeinheit an der in Fig. 1 beschriebenen Ausführungsform erläutert.

Zur Durchführung des erfindungsgemäßen Verfahrens ist eine Vorrichtung erforderlich, die in eine Zentrifuge eingebaut wird. Die Vorrichtung enthält einen in der Fig. 1 im Querschnitt dargestellten zylindersymmetrischen Tiegel 10, der um seine Zylinderachse drehbar gelagert ist. Der Tiegel 10 ist zu diesem Zweck mit einer in Richtung seiner Symmetrieachse verlaufenden Rotorwelle 4 starr verbunden.

Der Tiegel 10 enthält ein Vorratsgefäß 3 zur Aufbewahrung der flüssigen Schmelzlösung 7. Nach oben ist der Tiegel 10 durch einen Deckel 5 abgeschlossen. Ferner enthält der Tiegel 10 einen doppelwandigen Kegelstumpf, an dessen inneren und/oder äußeren Mantelflächen 1a, 1b Substrate oder Vorratsplatten 2a, 2b befestigt werden können. die Funktion der Vorratsplatten wird weiter unten noch erläutert werden. Oben ist der ringförmige Zwischenraum zwischen der inneren und äußeren Zylinderwand bis auf einen engen Spalt 8 verschlossen. Nach unten mündet der Zwischenraum in das im wesentlichen zylindersymmetrische und mit dem Tiegel 10 einstückige Vorratsgefäß 3. Dieses Vorratsgefäß ist so weit gefüllt, daß Substrate und Lösung durch die Rotation des mit dem Vorratsgefäß 3 einstückigen Tiegels 10 in Kontakt gebracht werden. In einer bevorzugten Ausführungsform ist die Achse des Tiegels 10 vertikal. In einer anderen vorteilhaften Ausführungsform liegt die Zylinderachse in einem vorher einzustellenden oder auch variablen Winkel zwischen 0° und 90° zur Vertikalen. Statt eines doppelwandigen Kegelstumpfes wie in der Fig. 1 ist auch ein doppelwandiger Zylinder als Tiegel 10 verwendbar. Entscheidend ist die Ausrichtung der an den Wänden montierten Substrate in bezug zur Vertikalen. Bei rotierendem Tiegel wirkt nämlich auf die im Wandzwischenraum befindliche Flüssigkeit die Zentrifugalkraft und die Schwerkraft ein. Im Betrieb sollte sich nach Möglichkeit die Resultante aus Zentrifugalkraft und Schwerkraft senkrecht zu der Substratoberfläche einstellen. Daher können - unabhängig von der Ausrichtung der inneren und äußeren Zylinderwand - die Substrate derart angebracht werden, daß die Resultante aus Zentrifugalkraft und Schwerkraft senkrecht auf ihr steht. Auch eine variable Halterung der Substrate zur Ausrichtung ihrer Oberflächen abhängig von der momentanen Drehzahl ist denkbar.

Das Substrat wird, je nachdem, ob die im Lösungsmittel gelöste Substanz leichter oder schwerer ist als das Lösungsmittel, bzw. je nachdem, ob die entsprechenden volumenbezogenen Atom- bzw. Molekulargewichte von Lösungsmittel und Gelöstem schwerer oder leichter sind, wird das Substrat an der inneren oder äußeren Zylinderwand (selbstverständlich im Inneren des Doppelzylinderraumes) angebracht. Beispielsweise werden zur Herstellung von Siliziumschichten aus einer Lösung von Silizium in Gallium die Substrate an der inneren Wand angebracht, da Gallium schwerer ist als Silizium. Wenn der Doppelzylinder in Rotation versetzt ist, bildet sich infolge des Einwirkens der Fliehkraft (+Schwerkraft) in der Lösung "über" dem Substrat 2a ein Konzentrationsanstieg aus, der, von der Drehzahl abhängig, zu einer lokalen Übersättigung der Lösung an der Grenzfläche zum Substrat 2a hin, d.h. an der Wachstumsfläche führt. Der Grad der Übersättigung läßt sich aus den Daten des entsprechenden Phasendiagramms, aus den geometrischen Daten und den Betriebsdaten, z.B. der Umdrehungszahl der Rotorwelle, mit ausreichender Genauigkeit abschätzen. Auf dem Substrat 2a wächst eine kristalline Schicht 11 auf.

Bei dem angeführten Beispiel sind Zentrifugal-Beschleunigungen der Größenordnung 10g erforderlich (g = Erdbeschleunigung). In jedem Fall muß eine Zentrifugal-Beschleunigung gewählt werden, die höher ist als die Beschleunigung, die bei den Verfahren nach dem Stand der Technik jeweils als ausreichend erachtet wird, um die Lösung über das Substrat zu transportieren.

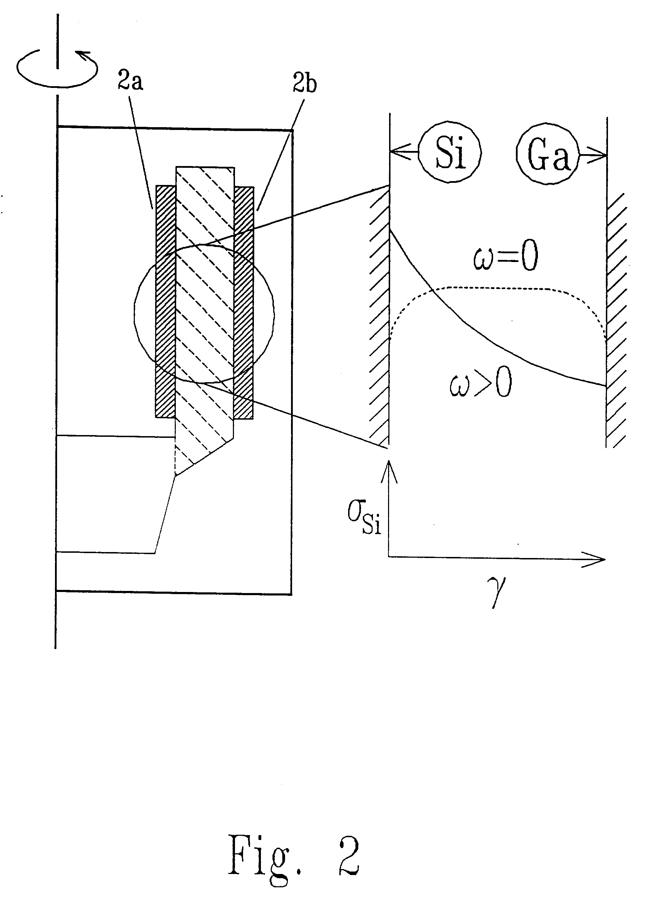

In der Figur 2 ist dies noch einmal schematisch dargestellt, wobei die in dem Teilausschnitt gezeigten Kurvenverläufe die relative Konzentration σᵣₑₗ an Si-Atomen in der Ga-Lösung in Abhängigkeit vom Radius von der Zylinderachse bei ω = 0 und ω >0 (ω Winkelgeschwindigkeit des Tiegels) wiedergeben.

Nach Beendigung der Abscheidung der kristallinen Schicht 11 wird die Drehzahl des Tiegels erhöht. Dabei zieht sich die Lösung von der Oberfläche der kristallinen Schicht ab und fließt nach außen und oben durch den engen Spalt 8 in den Innenraum 6. Von dort fließt sie, wenn der Tiegel 10 gebremst wird, durch die Öffnungen 9 wieder in den unteren Teil des Vorratsgefäßes 3 zurück.

Bei der Abscheidung hochwertiger kristalliner Schichten auf einem artfremden Substrat müssen in vielen Fällen Nukleationsbarrieren überwunden werden. Diese Nukleationsbarrieren lassen sich durch eine erhöhte Übersättigung der Lösung, die durch Einwirkung der Fliehkräfte über der Substratoberfläche erzeugt wird, überwinden. Eine entsprechende für die Nukleation notwendige Übersättigung im gesamten Lösungsvolumen würde zu spontaner Keimbildung innerhalb der Lösung führen, welche folglich (da die Keime weiterwachsen) die Lösung entsättigen und die gewünschte Abscheidung auf dem Fremdsubstrat verhindern würde.

Liegt ein Substrat vor, dessen Oberfläche nicht glatt ist, sondern z.B. eine gewisse Rauhigkeit und Poren aufweist, so ist es in der Zentrifuge möglich, bei genügend hoher Drehzahl das der Schichtbildung dienende gelöste Material auch bei großen Werten der Oberflächenspannung der Lösung unter Anwendung von Druck in die feinen Vertiefungen und rückspringenden Volumina an der Oberfläche der Substrate eindringen zu lassen. Der Druck, mit dem die gelöste Substanz auf das Substrat gepreßt wird, ist durch die Drehzahl der Zentrifuge regulierbar und ergibt sich aus der bereits weiter oben erläuterten bevorzugten Abscheidung des gelösten Materials an der Substratoberfläche aufgrund der an der Oberfläche erhöhten Konzentration. Diese bevorzugte Abscheidung an der Substratoberfläche bewirkt, daß die rückspringenden Volumina und Vertiefungen der Oberfläche des Trägermaterials mit kristallinem Material gefüllt werden. Bei fortgesetzter Abscheidung bildet sich dadurch eine zusammenhängende kristalline Schicht, die - zusätzlich zu einer unter geeigneten Bedingungen entstandenen Haftverbindung - formschlüssig mit dem Trägermaterial verbunden ist.

Setzt man gleichzeitig ein Trägermaterial (oder Substrat) z.B. in der Position 2a, und eine Vorratsplatte aus dem abzuscheidenden Material z.B. in der Position 2b, in den Doppelzylinder ein, so wird in dem rotierenden Behälter das spezifisch leichtere, sich in Lösung befindliche Molekül auf dem Substrat abscheiden, während von der Vorratsplatte in Position 2b Material gelöst wird, da das System versucht, das beschriebene Dichtegefälle (s. Fig. 2) aufrechtzuerhalten. Man erhält also aufgrund des Dichtegefälles an gelöstem Material einen anhaltenden Transport in Richtung von der Vorratsplatte, wo Material gelöst wird, zum Substrat oder Trägermaterial, wo das gelöste Material als kristalline Schicht abgeschieden wird. Dieser Transport findet statt, auch wenn das System vollständig isotherm ist. Bei diesem Verfahren ist es also nicht notwendig, für den Substanztransport eine Temperaturdifferenz zwischen dem Trägermaterial und der Vorratsplatte zur Abscheidung der kristallinen Schicht herzustellen bzw. aufrechtzuerhalten. Die kristalline Schicht wächst vom Beginn des Wachstums an bis zum geplanten Abschluß vollständig isotherm, d.h. daß sowohl die Wachstumsfront der gewünschten kristallinen Schicht als auch die Anlösefläche des gegenüberliegenden Vorratssubstrats während der ganzen Zeit des Wachstums dieselbe Temperatur haben kann. Auf diese Weise läßt sich kristallines Material mit gleichmäßigen Eigenschaften gewinnen. Die Lösungszüchtung insbesondere von dicken, homogenen Schichten aus Materialien beim Vorliegen von komplizierten Phasendiagrammen wird bei der beschriebenen isothermen Abscheidung ermöglicht bzw. erheblich erleichtert. Insbesondere gelingt es, bei tiefen Temperaturen, bei denen die Löslichkeiten meist klein sind, noch dicke kristalline und homogene Schichten abzuscheiden, da die Lösung beim Vorhandensein eines Vorratssubstrats ständig nachgesättigt wird. Damit ist die Dicke der kristallinen Schicht nicht begrenzt durch die Menge des zu einem bestimmten Zeitpunkt in Lösung befindlichen Materials.

Die beschriebene Nachsättigung durch Materialtransport von der Vorratsplatte in Richtung auf das Substrat kann jedoch auch zusätzlich dadurch verstärkt werden, daß eine Temperaturdifferenz zwischen der Vorratsplatte 2b und dem Substrat 2a zusatzlich eingestellt wird.

Für die Herstellung polykristalliner Schichten auf metallischem "Substrat" als Trägermaterial verwendet man für die Abscheidung zunächst ein Formteil mit mikroskopisch glatter Oberfläche. Die glatte Oberfläche kann auch in geeigneter Weise profiliert sein, z.B. als Anwendung für Solarzellen für den sogenannten "Lichteinfang" (verbesserte Ausnutzung des auf die Solarzelle auftreffenden und reflektierten Lichts). An der Oberfläche des Formteils soll aber das kristallisierende Material nicht haften. Materialien für derartige Formteile können z.B. bestimmte Sorten von Graphit sein. Nach Abscheidung der kristallinen Schicht, wie oben beschrieben, auf einem Formteil dieser Art läßt man einen Teil, d.h. einen dünnen Film des verwendeten metallischen Lösungsmittels auf der Oberfläche der gewachsenen kristallinen Schicht erstarren. Die Dicke des auf der kristallinen Schicht erstarrenden Metallfilms ist wählbar und wird so eingestellt, daß die entstandene Doppelschicht aus Metall und kristallinem Material selbsttragend ist. Hebt man die erhaltene Doppelschicht nun von dem nichthaftenden Formteil ab, so hat man den gewünschten kristallinen Film auf metallischem Trägermaterial bzw. "Substrat".

Besteht die abgeschiedene kristalline Schicht z.B. aus einem Halbleitermaterial, so bietet die so gewonnene Struktur bereits den für viele Anwendungen, insbesondere für Solarzellen, benötigten hochwertigen und flächigen Metall-Halbleiterkontakt.

Wie in früheren Arbeiten gezeigt wurde, lassen sich unter Verwendung einer Zentrifuge kristalline Schichten auch in Form von epitaktischen "Dotierungs-Mehrfachschichten" oder von kompositionell unterschiedlichen "heteroepitaktischen Mehrfachschichten" abscheiden. Die Abscheidung der Mehrfachschichten geht dabei in einer automatisierten Anlage in einem einzigen Epitaxie-Prozeßlauf vor sich. Bei geeigneter Wahl der Materialien und Prozeßparameter gewinnt man damit bereits in einem einzigen Epitaxie-Prozeßlauf die z.B. für Solarzellen benötigten Strukturelemente, d.h. den für die Funktion wesentlichen Teil der Zelle.

Wie bereits erwähnt, zählt zu den Vorteilen des Verfahrens, daß die Notwendigkeit der Verwendung von kristallinem Substratmaterial, das aus der Schmelze gezüchtet wurde, vollständig entfällt. Weiterhin lassen sich bei der Herstellung der kristallinen Schichten durchweg Temperaturen anwenden, die wesentlich niedriger sind, als die Schmelztemperaturen der abgeschiedenen kristallinen Materialien. Dazu muß noch hervorgehoben werden, daß die beschriebene Vorrichtung das nach dem Stand der Technik übliche Verfahren der Diffusion, das naturgemäß bei sehr hohen Temperaturen stattfindet und zur Herstellung von Schicht-Strukturen, wie z.B. von pn-Übergängen, verwendet wird, vollständig überflüssig macht. Stattdessen werden in einem einzigen Epitaxieprozeßablauf in einer automatisierten Anlage und nach dem oben beschriebenen Verfahren kristalline Mehrfachschichten, z.B. pn-Schichten, bei tiefen Temperaturen hergestellt.

## Patentansprüche

1. Verfahren zur Ausbildung einer Schicht auf mindestens einem Substrat, wobei eine Flüssigkeit, die das der Schichtbildung dienende Material enthält, über die zu beschichtende Oberfläche des Substrats strömt, **dadurch gekennzeichnet**, daß
in einer Richtung senkrecht zu der Strömungsrichtung der Flüssigkeit ein Konzentrationsgefälle des der Schichtbildung dienenden Materials derart erzeugt wird, daß die Konzentration des der Schichtbildung dienenden Materials an einer Seite der Flüssigkeit maximal wird.

2. Verfahren nach Anspruch 1, **dadurch gekennzeichnet**, daß das Substrat (2a) auf der Seite der Flüssigkeit angebracht wird, auf der die Konzentration des der Schichtbildung dienenden Materials maximal wird.

3. Verfahren nach Anspruch 1 oder 2, **dadurch gekennzeichnet**, daß auf die Flüssigkeit eine Zentrifugalkraft ausgeübt wird.

4. Verfahren nach Anspruch 3, **dadurch gekennzeichnet**, daß die Resultante aus der Zentrifugalkraft und der Schwerkraft eine auf der Oberfläche des Substrats senkrecht stehende Komponente erhält.

5. Verfahren nach Anspruch 4, **dadurch gekennzeichnet**, daß die Resultante aus der Zentrifugalkraft und der Schwerkraft auf der Oberfläche des Substrats (2a) senkrecht steht.

6. Verfahren nach Anspruch 1, **dadurch gekennzeichnet**, daß daß das Substrat (2a) derart in einem Abstand von einer Wand angeordnet wird, daß die Flüssigkeit im Betrieb mit dem Substrat und der Wand in Kontakt steht.

7. Verfahren nach Anspruch 6, **dadurch gekennzeichnet**, daß die Wand durch eine Vorratsplatte (2b) gebildet wird, und daß die Vorratsplatte das der Schichtbildung dienende Material enthält.

8. Verfahren nach Anspruch 7, **dadurch gekennzeichnet**, daß zwischen der Vorratsplatte (2b) und dem Substrat (2a) eine Temperaturdifferenz eingestellt wird.

9. Vorrichtung zur Durchführung des Verfahrens nach Anspruch 1, **gekennzeichnet durch**
einen zylindersymmetrischen Tiegel (10), der um seine Zylinderachse drehbar gelagert ist, und ein Vorratsgefäß (3) zur Aufnahme einer flüssigen Lösung (7) aufweist,
und der eine äußere zylindersymmetrische Mantelfläche (1b)
und eine innere zylindersymmetrische Mantelfläche (1a) aufweist,
wobei die Mantelflächen (1a, 1b) derart voneinander beabstandet sind, daß ein von der Flüssigkeit zu durchströmender Zwischenraum gebildet wird, und daß an die dem Zwischenraum jeweils zugewandten inneren Wände der Mantelflächen (1a, 1b) ein oder mehrere Substrate (2a) montierbar sind.

10. Vorrichtung nach Anspruch 9, **dadurch gekennzeichnet**, daß an die dem Zwischenraum jeweils zugewandten inneren Wände der Mantelflächen (1a, 1b) ein oder mehrere Vorratsplatten (2b) montierbar sind.

11. Vorrichtung nach Anspruch 9, **dadurch gekennzeichnet**, daß die Substrate (2a) derart montierbar sind, daß ihre Oberflächen in einer vertikalen Ebene liegen oder mit einer vertikalen Ebene einen Winkel einschließen.

12. Vorrichtung nach Anspruch 9, **dadurch gekennzeichnet**, daß der Zwischenraum ein unteres, dem Vorratsgefäß (3) zugewandtes Eintrittsende und ein oberes Austrittsende aufweist.
